(19) **Europäisches Patentamt / European Patent Office / Office européen des brevets**

(11) **EP 2 028 523 B1**

(12) **EUROPEAN PATENT SPECIFICATION**

(45) Date of publication and mention
of the grant of the patent:
**12.05.2010 Bulletin 2010/19**

(51) Int Cl.:
*G02B 26/08* (2006.01)  *H03H 9/02* (2006.01)
*G02B 6/35* (2006.01)

(21) Application number: **08160494.4**

(22) Date of filing: **16.07.2008**

(54) **Oscillating device, light deflector, and image forming apparatus using the light deflector**

Oszillierende Vorrichtung, Lichtdeflektor und Bilderzeugungsvorrichtung, die diesen verwendet

Dispositif d'oscillation, déflecteur de lumière, et appareil de formation d'images utilisant le déflecteur de lumière

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **30.07.2007 JP 2007197393**

(43) Date of publication of application:
**25.02.2009 Bulletin 2009/09**

(73) Proprietor: **Canon Kabushiki Kaisha**
**Tokyo 146-8501 (JP)**

(72) Inventors:
• **KAZUTOSHI, Torashima**
**3-chome,**
**Ohta-ku,**
**Tokyo Tokyo 146-8501 (JP)**

• **TAKAHISA, Kato**
**3-chome,**
**Ohta-ku,**
**Tokyo Tokyo 146-8501 (JP)**

(74) Representative: **TBK-Patent**
**Bavariaring 4-6**
**80336 München (DE)**

(56) References cited:
**EP-A- 1 275 997**  **JP-A- 2003 019 700**
**US-A- 5 740 150**

**Description**

BACKGROUND OF THE INVENTION

Field of the Invention

The present invention relates to oscillating devices, light deflectors, and optical apparatuses using the light deflectors, such as image forming apparatuses and displays. Light deflectors are suitably used in, for example, projection displays that project images by deflecting light and performing scanning, image forming apparatuses using electrophotography processes, such as laser beam printers and digital copying machines.

Description of the Related Art

Various optical scanning systems and optical scanning apparatuses serving as light deflectors that deflect light by sinusoidally oscillating movable portions having reflecting surfaces are known. Compared to optical scanning systems using rotatable polygonal mirrors, optical scanning systems using light deflectors that sinusoidally oscillate utilizing resonance have significantly smaller light deflectors and consume less power. In particular, light deflectors made of single-crystal silicon, by a semiconductor process, theoretically produce no metal fatigue and have better durability.

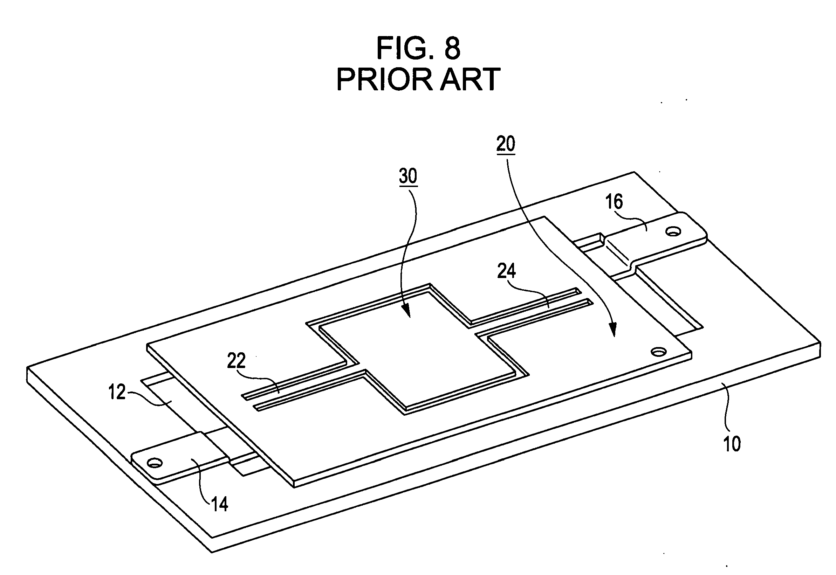

United States Patent No. 4317611 discloses a light deflector made of silicon, which is shown in FIG. 8 as an exemplary light deflector. FIG. 8 is a perspective view of the light deflector.

The light deflector shown in FIG. 8 has a supporting portion 20, a movable portion 30, and torsion springs 22, 24 connecting the movable portion 30 to the supporting portion 20 in a manner allowing the movable portion 30 to torsionally oscillate. The light deflector is made of a silicon wafer, using a photolithography process and an etching process used in a semiconductor manufacturing method.

The movable portion of the oscillating device torsionally oscillates by a predetermined angle and is subjected to great angular acceleration. Thus, the movable portion is subjected to an inertial force due to its own weight during driving and may be deformed. In particular, when laser scanning is performed using a light deflector whose movable portion has a reflecting surface, the deformation of the movable portion affects the optical characteristics of scanning light.

SUMMARY OF THE INVENTION

The present invention provides an oscillating device in which the amount of deformation of a movable portion during torsional oscillation is reduced.

The present invention in its first aspect provides an oscillating device as specified in claims 1 to 4.

The present invention in its second aspect provides a light deflector as specified in claims 5 and 6.

The present invention in its third aspect provides an image forming apparatus as specified in claim 7.

This configuration further reduces the amount of deformation of the movable portion, compared to a configuration in which the principal surface of the movable portion lies in another crystal plane or the crystal orientation is another orientation. Accordingly, it is possible to provide an oscillating device that maintains the flatness of the movable portion during torsional oscillation.

Further features of the present invention will become apparent from the following description of exemplary embodiments with reference to the attached drawings.

BRIEF DESCRIPTION OF THE DRAWINGS

FIGS. 1A and 1B are respectively a plan view and a sectional view of an oscillating device according to an embodiment of the present invention, and also respectively a plan view and a sectional view of a light deflector according to Example 1.

FIGS. 2A and 2B are respectively a plan view and a sectional view of a light deflector according to Example 2 of the present invention.

FIG. 3 is a plan view of a light deflector according to Example 3 of the present invention.

FIG. 4 is a schematic diagram of an image forming apparatus according to Example 4 of the present invention.

FIGS. 5A, 5B, and 5C show deformation of the light deflector.

FIG. 6 is a graph showing the relationships between the amounts of deformation of movable portions of the present invention and the crystal planes of substrates of which the movable portions are made.

FIG. 7 is a graph showing the relationships between the torsion spring constants of torsion springs of the present invention and the crystal planes of substrates of which the torsion springs are made.

FIG. 8 is a perspective view of a known light deflector.

DESCRIPTION OF THE EMBODIMENTS

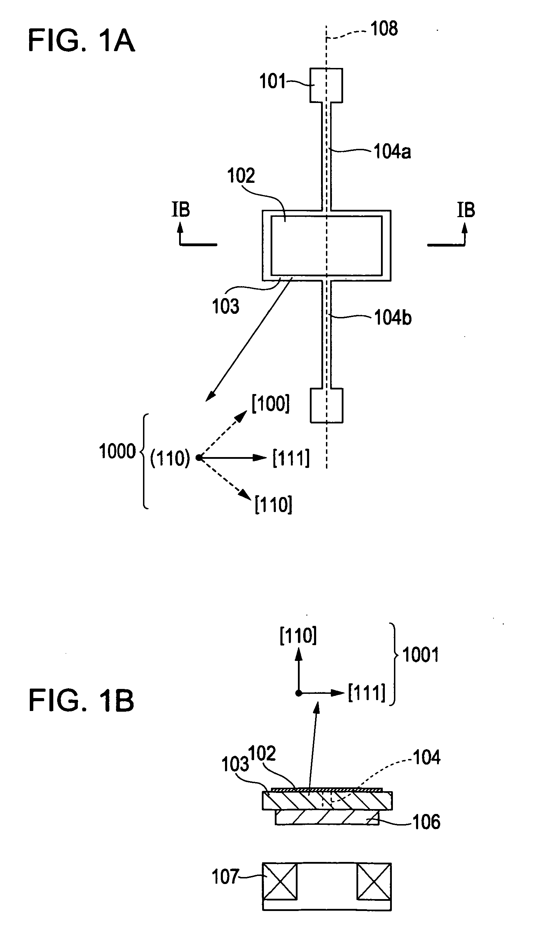

An embodiment of the present invention will now be described with reference to FIGS. 1A and 1B. FIG. 1A is a plan view of an oscillating device of the present invention, and FIG. 1B is a sectional view of the oscillating device shown in FIG. 1A, taken along line IB - IB. The oscillating device according to the present embodiment has supporting portions 101, a movable portion 103, and torsion springs 104a, 104b connecting the movable portion 103 to the supporting portions 101 in a manner allowing the movable portion 103 to torsionally oscillate about a torsional axis 108. The supporting portions 101 are fixed to a fixed member such as a supporting substrate so that the supporting portions 101 do not move when the movable portion 103 torsionally oscillates. The oscillating device according to the present embodiment may be used as a light deflector by providing a reflecting surface 102 on the surface of the movable portion 103. The reflecting surface 102 may be made of a thin film of, for example, gold or copper, and a protective film may be formed thereon. Alternatively, the reflecting surface 102 may be made of a dielectric multilayer film.

The movable portion 103 is made of a single-crystal silicon substrate, and the principal surface (the surface having the reflecting surface 102 in FIGS. 1A and 1B) of the movable portion 103 lies in the (110) crystal plane or the planes equivalent thereto (i.e., the {110} planes). The crystal orientation parallel to the principal surface of the movable portion 103 and perpendicular to the torsional axis 108 is the [111] orientation or the orientations equivalent thereto.

Herein, the planes equivalent to the (111) crystal plane, such as the (-1-1-1) crystal plane and the (-111) crystal plane, are referred to as "(111) equivalent planes" (i.e., the {111} planes). Likewise, the orientations equivalent to the [111] orientation, such as the [-1-1-1] orientation and the [-111] orientation, are referred to as "[111] equivalent orientations".

The oscillating device according to the present embodiment is made of, for example, a single-crystal silicon substrate whose principal surface lies in the (110) crystal plane, and has the supporting portions 101, the movable portion 103, and the torsion springs 104a, 104b that are integrally formed.

In FIGS. 1A and 1B, a crystal orientation 1000 of the movable portion 103 parallel to the principal surface of the movable portion 103 and perpendicular to the torsional axis 108 is the [111] orientation. Herein, the [111] orientation refers to the [111] orientation give or take 5 degrees, including substantially the [100] orientation. Where the crystal orientation 1000 is within this range, the amounts of deformation of the movable portions due to their own weight are substantially uniform.

The oscillating device according to the present embodiment further has a driving unit configured to drive the movable portion 103. Examples of the driving unit include a coil and a magnet when the driving unit is of an electromagnetic type, an electrode when the driving unit is of an electrostatic type, and a piezoelectric element when the driving unit is of a piezoelectric type. Referring to FIG. 1B, for example, the movable portion 103 has a hard magnet 106, and is magnetized perpendicular to the torsional axis 108 (the left-right direction in FIG. 1B). The hard magnet 106 may be formed on the movable portion 103 by a sputtering process, or the hard magnet 106 may be attached to the movable portion 103. When a driving current is applied from a driving control unit (not shown) to a coil 107 serving as a driving unit, a magnetic field is generated. Then, a torque is applied to the movable portion 103, thereby driving the oscillating device. If an AC current is applied to the coil 107, the oscillating device torsionally oscillates at the frequency of the AC current. In addition, if an AC current having a frequency equal to the resonance frequency of the oscillating device of the present invention is applied to the coil 107, the oscillating device torsionally and resonantly oscillates while consuming less power.

Principles of the present invention are described below.

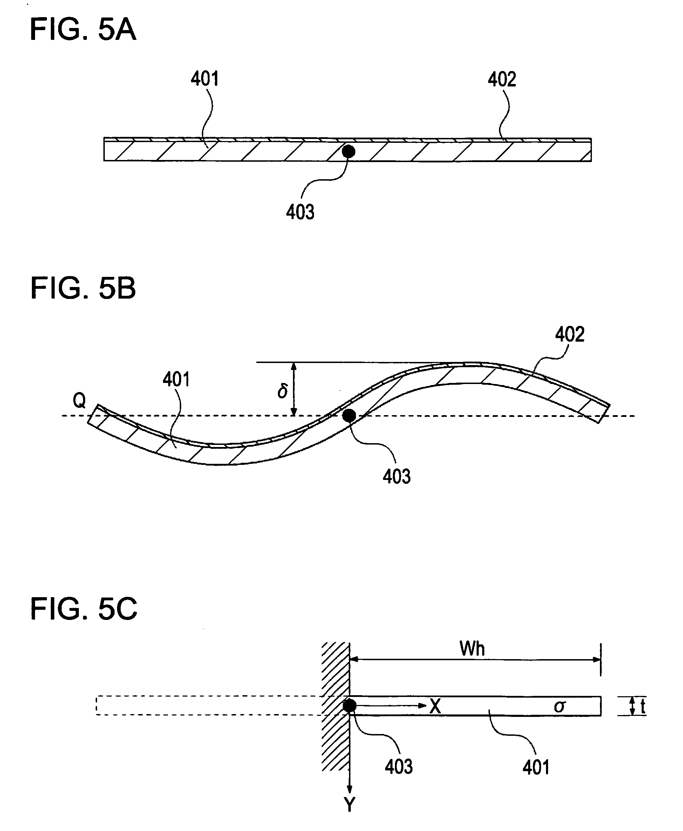

FIG. 5A is a sectional view of a movable portion 401 in the shape of a flat plate (rectangular parallelepiped), taken along a line perpendicular to the torsional axis. Assuming that the oscillating device is driven to torsionally oscillate at a frequency around the resonance frequency, the displacement angle of the movable portion 401 changes sinusoidally with time. The most significant deformation occurs at a portion subjected to the greatest angular acceleration.

FIG. 5B is a sectional view of the movable portion 401 being deformed. As shown in FIG. 5B, when the movable portion 401 is deformed, the reflecting surface 402 provided on the movable portion 401 is also deformed. When the oscillating device is used as a light deflector, a significant deformation of the movable portion 401 degrades the flatness of the reflecting surface 402, leading to a significant degradation in the optical characteristics of the light deflector.

The approximation model shown in FIG. 5B shows the deformation of the movable portion 401 during torsional oscillation, when the movable portion 401 is in the shape of a rectangular parallelepiped. The deformation of the movable portion 401 is point symmetrical with respect to the torsional axis 403, and may be approximated by the deformation of a beam as shown in FIG. 5C, which is fixed at one end corresponding to the torsional axis 403. When the movable portion 401 torsionally oscillates and is subjected to an angular acceleration of $\Theta(2\pi f)^2$ (where $\Theta$ is the displacement angle, f is the frequency of torsional oscillation), the deformation (deflection) y of the beam shown in FIG. 5C is expressed in Expression 1.

[Expression 1]

$$y = 12 \cdot \Theta \cdot (2\pi f)^2 \cdot \frac{\rho W_h^5}{Et^2} \left( \frac{x^5}{120} - \frac{x^3}{12} + \frac{x^2}{6} \right)$$

where x is the dimensionless distance shown in FIG. 5C, ρ is the density of the component, E is the Young's modulus of the component, t is the thickness, and Wh is half the width W of the mirror.

The distance δ between the deformation (deflection) y and the reference plane Q affects the optical characteristics of the reflecting surface 402. Where the reference plane Q is as shown in FIG. 5B, the distance δ is expressed in Expression 2.

[Expression 2]

$$\delta \approx 0.23 \cdot \Theta \cdot f^2 \cdot \frac{\rho W^5}{Et^2}$$

The distance δ is proportional to the displacement angle Θ, the width W of the mirror to the fifth power, and the frequency f squared. Thus, in the case of a larger reflecting surface area, a larger deflection angle, or a higher-frequency driving signal, the deformation of the movable portion due to its own weight becomes significant.

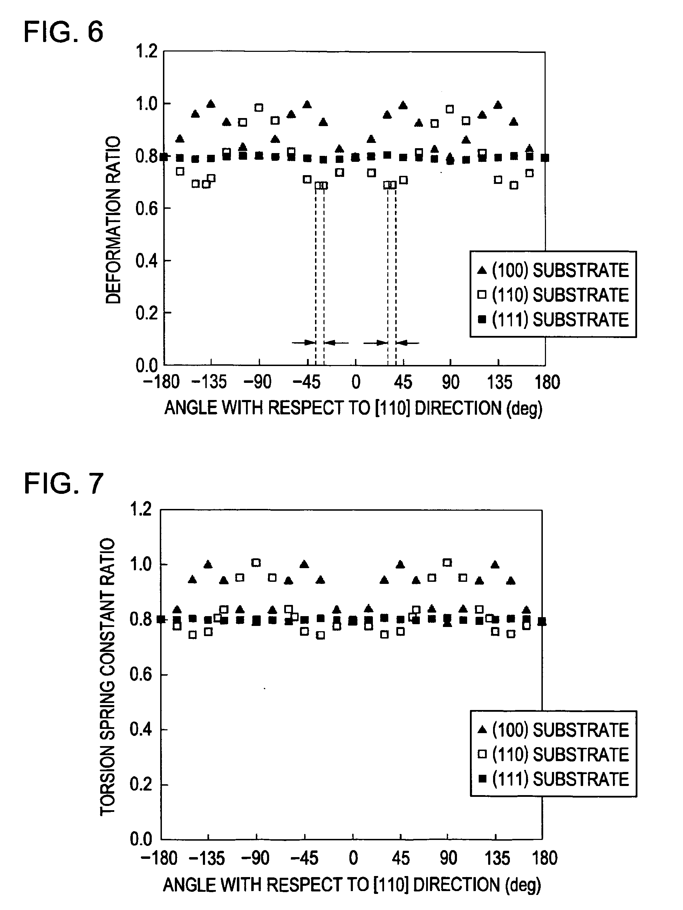

FIG. 6 is a graph showing the relationships between the amounts of deformation of movable portions of the present invention and the crystal planes of substrates of which the movable portions are made, calculated using a finite element method. This calculation took into account the crystal anisotropy of silicon.

The following physical properties were used in the calculation using a finite element method: the density of silicon = 2300 kg/m$^3$, and the stiffness coefficient (unit: Pa) shown below, which was used instead of Young's modulus (unit: Pa) in order to take into account the anisotropy of single-crystal silicon.

[Expression 3]

$$\text{Stiffness Coefficient} = \begin{pmatrix} C11 & C12 & C12 & 0 & 0 & 0 \\ C12 & C11 & C12 & 0 & 0 & 0 \\ C12 & C12 & C11 & 0 & 0 & 0 \\ 0 & 0 & 0 & C44 & 0 & 0 \\ 0 & 0 & 0 & 0 & C44 & 0 \\ 0 & 0 & 0 & 0 & 0 & C44 \end{pmatrix}$$

where C11 = 167.4 GPa, C12 = 65.23 GPa, and C44 = 79.57 GPa.

It becomes possible to perform an analysis taking into account the crystal anisotropy, by creating finite element models of the components, such as a movable portion and torsion springs, using the above-noted physical properties, and by performing calculation using a finite element method.

In FIG. 6, the ordinate is the deformation ratio of movable portions, and the abscissa is the angle with respect to the [110] orientation. The deformation ratio of movable portions represents the amount of deformation of movable portions expressed as a decimal, where 1 is the amount of deformation of a movable portion whose principal surface lies in the (100) crystal plane and the crystal orientation parallel to the principal surface and perpendicular to the torsional axis is the [100] orientation (at this time, the angle with respect to the [110] orientation is 45 degrees, for example).

The angle with respect to the [110] orientation represents the angle of the crystal orientation parallel to the principal surface of the movable portion and perpendicular to the torsional axis with respect to the [110] orientation existing in the principal surface of the movable portion. Thus, when the crystal orientation parallel to the principal surface of the movable portion and perpendicular to the torsional axis is the [110] orientation, the angle with respect to the [110] orientation is 0 degrees.

Herein, a (100) substrate refers to a substrate whose principal surface lies in the (100) crystal plane. Likewise, a (110) substrate and a (111) substrate refer to substrates whose principal surfaces lie in the (110) crystal plane and the (111) crystal plane, respectively. For example, in the case of a (100) substrate, the crystal orientation that makes angles of $\pm 45$ degrees and $\pm 135$ degrees with respect to the [110] orientation is the [100] orientation. The crystal orientation that makes angles of 0 degrees, $\pm 90$ degrees, and $\pm 180$ degrees with respect to the [110] orientation is the [110] orientation. In the case of a (110) substrate, the crystal orientation that makes angles of 0 degrees and $\pm 180$ degrees with respect to the [110] orientation is the [110] orientation. The crystal orientation that makes angles of $\pm 90$ degrees with respect to the [110] orientation is the [100] orientation, and the crystal orientation that makes angles of $\pm 35.3$ degrees and $\pm 144.7$ degrees is the [111] orientation. In the case of a (111) substrate, the crystal orientation that makes angles of 0 degrees and $\pm 180$ degrees is the [110] orientation.

As shown in FIG. 6, where the crystal orientation parallel to the principal surface of the movable portion and perpendicular to the torsional axis makes an angle in the range from 0 degrees to 60 degrees with respect to the [110] orientation, the deformation ratio of movable portions made of a (110) substrate is smaller than those of movable portions made of (100) and (111) substrates. Further, where the crystal orientation parallel to the principal surface of the movable portion and perpendicular to the torsional axis makes an angle of 35.3 degrees with respect to the [110] orientation, the deformation ratio of movable portions made of a (110) substrate becomes smallest. At this time, the crystal orientation parallel to the principal surface of the movable portion and perpendicular to the torsional axis is the [111] orientation. Where the crystal orientation parallel to the principal surface of the movable portion and perpendicular to the torsional axis is the [111] orientation give or take 5 degrees, the amounts of deformation of the movable portions due to their own weight are substantially uniform.

As has been described, in the oscillating device according to the present embodiment, it is possible to reduce the amount of deformation of the movable portion having the reflecting surface during high-speed driving, utilizing the crystal anisotropy of silicon substrates. Accordingly, a light deflector using the oscillating device according to the present embodiment prevents deterioration in spot shape of deflected light (reflected light) during high-speed driving.

Torsion springs of the oscillating device according to the present embodiment are described below.

The torsion springs of the oscillating device according to the present embodiment are made of single-crystal silicon, whose crystal orientation parallel to the torsional axis is the [111] orientation. The [111] orientation includes the orientations equivalent thereto.

The effect of the use of the torsion springs will be described. FIG. 7 is a graph showing the relationships between the torsion spring constants of torsion springs of the present invention and the crystal planes of substrates of which the torsion springs are made, calculated using a finite element method. This calculation took into account the crystal anisotropy of silicon. The calculation using a finite element method shown in FIG. 7 used the same physical properties as the calculation shown in FIG. 6.

In FIG. 7, the ordinate is the torsion spring constant ratio, and the abscissa is the angle with respect to the [110] orientation. The torsion spring constant ratio represents the torsion spring constant expressed as a decimal, where 1 is the torsion spring constant of a torsion spring whose principal surface lies in the (100) crystal plane and the crystal orientation parallel to the torsional axis is the [100] orientation (in the (100) substrate in FIG. 7, the angle with respect to the [110] orientation is 45 degrees).

The angle with respect to the [110] orientation represents the angle of the crystal orientation of the torsion springs parallel to the torsional axis with respect to the [110] orientation. Thus, when the angle of the crystal orientation of the torsion springs parallel to the torsional axis with respect to the [110] orientation is 0 degrees, the crystal orientation of the torsion springs parallel to the torsional axis is the [110] orientation. The cross section of the torsion springs, i.e., a section perpendicular to the torsional axis, is rectangular.

As shown in FIG. 7, where the crystal orientation of the torsion springs parallel to the torsional axis makes an angle in the range from 0 degrees to 60 degrees with respect to the [110] orientation, the torsion spring constant of torsion springs made of a (110) substrate is smaller than those of torsion springs made of (100) and (111) substrates. Further, where the crystal orientation of the torsion springs parallel to the torsional axis is the [111] orientation (the angle with respect to the [110] orientation is 35.3 degrees), the torsion spring constant ratio of torsion springs made of a (110) substrate becomes smallest. The [111] orientation refers to the [111] orientation give or take 10 degrees, including substantially the [111] orientation. Where the crystal orientation of the torsion springs parallel to the torsional axis is within this range, the torsion spring constant ratios of the torsion springs are uniform. This crystal orientation may be the orientations equivalent thereto.

A comparison between a torsion spring made of a substrate whose principal surface lies in a crystal plane having a small torsion spring constant ratio and a torsion spring made of a substrate whose principal surface lies in a crystal plane having a large torsion spring constant ratio is as follows. When torsion springs having the same torsion spring constant are to be made, a substrate whose crystal plane and orientation have a small torsion spring constant ratio makes a larger torsion spring than a substrate whose crystal plane has a large torsion spring constant ratio. For example, when torsion springs having the same length are to be made, the torsion spring having a smaller torsion spring constant ratio can have a larger width. When torsion springs are to be made of single-crystal silicon substrates having the same degree of manufacturing error, the influence of the manufacturing error on the torsion spring constant is smaller for the torsion spring having a larger width. Thus, a torsion spring made of a substrate whose crystal plane and orientation have a small torsion spring constant ratio is less affected by manufacturing error of the single-crystal silicon substrate.

This configuration reduces variations in torsion spring constants due to manufacturing error of the width of torsion springs or the like. Accordingly, the amount of deformation of the movable portion during high-speed driving and variation in resonance frequency due to manufacturing error can be reduced.

The torsion spring may be made of a (111) substrate. As shown in FIG. 7, the spring constants of torsion springs made of a (111) substrate are substantially uniform over the entire range of angles with respect to the [110] orientation. Accordingly, even if the crystal orientation of torsion springs parallel to the torsional axis is misaligned with the intended orientation during fabrication, the torsion spring constants of the torsion springs are substantially uniform. Thus, variations in resonance frequency due to manufacturing error can be reduced.

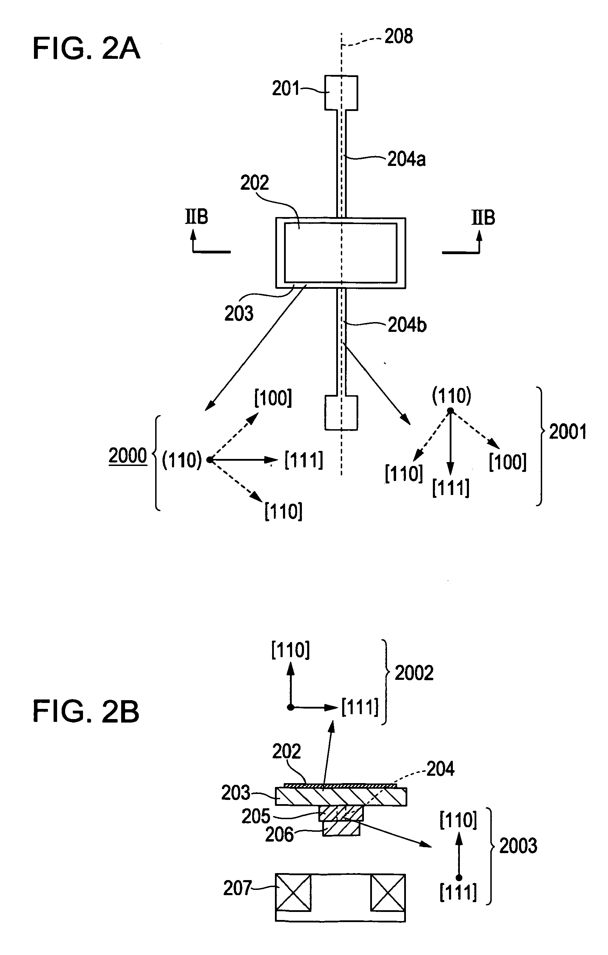

As shown in FIGS. 2A and 2B, in the oscillating device according to the present embodiment, it is possible to make the movable portion 203 separate from the supporting portions 201 and the torsion springs 204a, 204b. In that case, after the components are made, the movable portion 203 is adhered or bonded to a fixing portion 205.

The light deflector according to the present embodiment may have a plurality of movable portions, and a plurality of torsion springs configured to support the plurality of movable portions in a manner allowing the movable portion to torsionally oscillate about a single torsional axis. At least one of the plurality of movable portions has the reflecting surface. The plurality of movable portions oscillate about the torsional axis at a natural frequency serving as a reference frequency, and at a natural frequency that is an integral multiple of the reference frequency. The light deflector can perform an optical scanning in addition to a sinusoidal optical scanning, by oscillating the movable portions about the torsional axis at two or more natural frequencies simultaneously.

The image forming apparatus according to the present embodiment may have a light source, the light deflector, and a photosensitive body. The light deflector may deflect light emitted from the light source and irradiate the photosensitive body with a part of the light to form an electrostatic latent image. When a light deflector having a movable portion that is less deformed during high-speed driving is used, the spot shape of the reflected light is not deteriorated. Accordingly, deterioration in quality of images can be prevented.

A method for manufacturing the oscillating device according to the present embodiment will now be described.

When supporting portions, a movable portion, and torsion springs are integrally made of single-crystal silicon, for example, the following process is to be followed: First, the supporting portions, the movable portion, and the torsion springs are patterned on a (110) substrate, using a photolithography process. At this time, the crystal orientation parallel to the principal surface of the movable portion and perpendicular to the torsional axis is the [111] orientation. Then, non-patterned portions are removed using a wet or dry etching process. By integrally making the supporting portions, the movable portion, and the torsion springs using a semiconductor process, which has high processing accuracy, the oscillating devices can be fabricated highly accurately.

A method for fabricating a movable portion separately from supporting portions and torsion springs is described below.

The movable portion is made of a (110) substrate, using a wet or dry etching process or a dicing blade (a circular rotating blade). The movable portion is then joined to the torsion springs such that the crystal orientation parallel to the principal surface of the movable portion and perpendicular to the torsional axis is the [111] orientation. They may be joined together by adhesion or welding. By joining these components together, a light deflector having a movable portion that is less deformed during high-speed driving is fabricated.

Alternatively, components constituting light deflectors, such as movable portions and torsion springs, may be separately made of silicon wafers using a micromachining process. This reduces waste portions of the wafers, leading to an increase in the number of components obtained from a single silicon wafer. Accordingly, it is possible to provide inexpensive light deflectors. Further, by making components, such as torsion springs, separately from movable portions made of a (110) substrate, the torsion springs may be made of any desired material. For example, the torsion springs may be weakened to lower the resonance frequency, or may be hardened to increase the resonance frequency. Accordingly, it is possible to provide light deflectors with a high resonance frequency and light deflectors with a low resonance frequency. In particular, it is possible to provide light deflectors having torsion springs made of silicon, whose crystal orientation is oriented in any desired orientation.

The torsion springs are made of a (110) substrate, such that the crystal orientation parallel to the torsional axis is the [111] orientation. The movable portion and the torsion springs may be joined together by adhesion or welding. This reduces variation in torsion spring constant due to manufacturing error of the width of the torsion springs or the like. Accordingly, the defect rate of torsion springs due to manufacturing error can be reduced, leading to a reduction in manufacturing cost.

Alternatively, the torsion springs may be made of a (111) substrate. This reduces variations in spring constants due to misalignment of the crystal orientation of the torsion springs with the intended orientation during fabrication. Accordingly, again, the defect rate of torsion springs due to manufacturing error can be reduced, leading to a reduction in manufacturing cost.

The present invention will now be described in more detail with specific examples.

Example 1

A configuration of a light deflector according to Example 1 will be described with reference to FIGS. 1A and 1B. As described above, FIG. 1A is a plan view of a light deflector of the present invention, and FIG. 1B is a sectional view of the light deflector shown in FIG. 1A, taken along line IB - IB. The light deflector of the present invention has a supporting portions 101, a movable portion 103 having a reflecting surface 102, and torsion springs 104a, 104b connecting the movable portion 103 to the supporting portions 101 in a manner allowing the movable portion 103 to torsionally oscillate about a torsional axis 108. The movable portion 103 is made of a (110) substrate, such that the crystal orientation parallel to the principal surface (the surface having the reflecting surface 102 in FIGS. 1A and 1B) of the movable portion 103 and perpendicular to the torsional axis 108 is the [111] orientation.

That is, a crystal orientation 1000 of the movable portion 103 shows that the principal surface of the movable portion 103 lies in the (110) crystal plane, and the crystal orientation parallel to the principal surface of the movable portion 103 and perpendicular to the torsional axis 108 is the [111] orientation.

The movable portion 103 has a length perpendicular to the torsional axis 108 of 3.0 mm, a length parallel to the torsional axis 108 of a 1.0 mm, and a thickness of 0.3 mm. Although the movable portion 103 is in the shape of a rectangular parallelepiped, it may be in the shape of an elliptic cylinder or the like. The reflecting surface 102 is made of aluminum, by vacuum deposition. The supporting portions 101, the movable portion 103, and the torsion springs 104a, 104b are made of a (110) substrate, using a photolithography process and a dry etching process used in a semiconductor manufacturing method. The crystal orientation of the movable portion 103 parallel to the principal surface of the movable portion 103 and perpendicular to the torsional axis 108 is the [111] orientation.

The movable portion 103 has a hard magnet 106 and is magnetized perpendicularly to the torsional axis 108 (in the left-right direction in FIG. 1B). The light deflector according to Example 1 has a resonance frequency of about 2000 Hz. When an AC current having a frequency equal to the resonance frequency is applied to a coil 107, a magnetic field is generated, and a torque is applied to the movable portion 103. Thus, the movable portion 103 torsionally oscillates by an optical angle of 100 degrees, while consuming less power.

In this configuration, the largest amount of deformation of the movable portion 103 is about 40 nm, which is smaller than the amount of deformation of a movable portion to which the present invention is not applied. Accordingly, deterioration in spot shape of the reflected light can be reduced.

Example 2

A configuration of a light deflector according to Example 2 will be described with reference to FIGS. 2A and 2B. FIG. 2A is a plan view of the light deflector of the present invention, and FIG. 2B is a sectional view of the light deflector shown in FIG. 2A, taken along line IIB - IIB. The light deflector according to Example 2 has substantially the same configuration as the light deflector according to Example 1. In Example 2, torsion springs 204a, 204b are made of a (110) substrate. A crystal orientation 2001 of the torsion springs 204a, 204b parallel to the torsional axis 208 is the [111] orientation. Torsion springs oriented in the [111] orientation can be made of a (110) substrate. The cross section of the torsion springs, i.e., a section perpendicular to the torsional axis 208, is rectangular.

The movable portion 203 is made of a (110) substrate, using a photolithography process and a dry etching process used in a semiconductor manufacturing method. The movable portion 203 and the torsion springs 204a and 204b are bonded together, as shown in FIG. 2B. They are bonded together such that the crystal orientation parallel to the principal surface of the movable portion 203 and perpendicular to the torsional axis 208 is the [111] orientation.

By separately making the components, such as movable portions and torsion springs, of silicon wafers, waste portions of the wafers can be reduced, leading to an increase in the number of components obtained from a single silicon wafer, and a reduction in manufacturing cost.

As shown in FIG. 7, torsion springs made of a (110) substrate whose crystal orientation parallel to the torsional axis 208 is the [111] orientation have the smallest torsion spring constant.

This configuration reduces variations in torsion spring constants even if the torsion springs 204a, 204b have a manufacturing error of about 1 $\mu$m with respect to the width thereof, reducing a variation in resonance frequency due to manufacturing error. The amount of deformation of the movable portion during high-speed driving can be reduced by orienting the crystal orientation of the movable portion as above.

Example 3

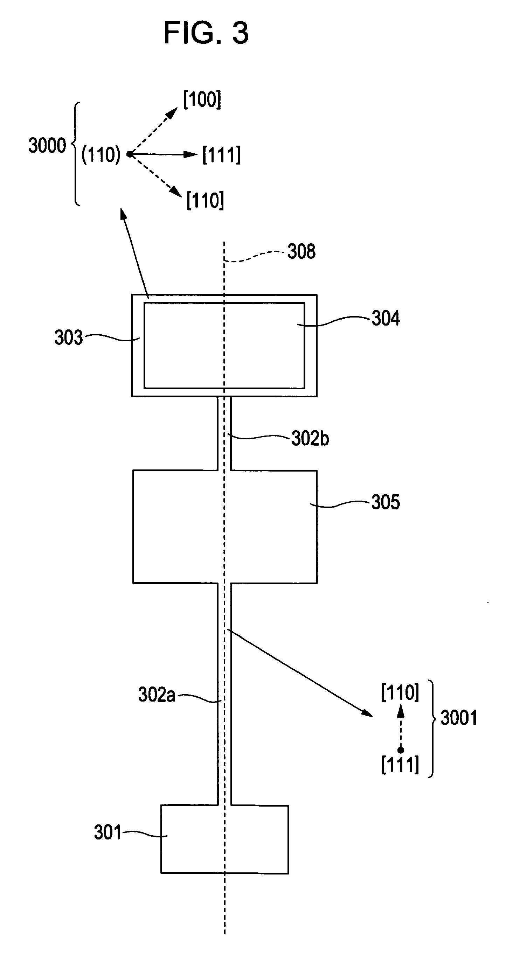

A configuration of a light deflector according to Example 3 will be described with reference to FIG. 3. The light deflector according to Example 3 has two movable portions 303 and 305. The movable portion 303 has a reflecting surface 304. The movable portions 303 and 305 are supported by a plurality of torsion springs 302a, 302b connecting the movable portions 303 and 305 to a supporting portion 301 in a manner allowing the movable portions 303 and 305 to torsionally oscillate about a single torsional axis.

The movable portion 303 has a length perpendicular to the torsional axis 308 of 3.0 mm, a length parallel to the torsional axis 308 of 1.0 mm, and a thickness of 0.3 mm. The movable portion 305 has a length perpendicular to the torsional axis 308 of 3.0 mm, a length parallel to the torsional axis 308 of 1.0 mm, and a thickness of 0.3 mm. The movable portion 305 has a permanent magnet (not shown) and can be driven by an electromagnetic force, similarly to Example 1.

The torsion springs 302a, 302b are made of a (111) substrate. As shown in FIG. 7, the spring constants of torsion springs made of a (111) substrate are substantially uniform over the entire range of angles with respect to the [110] orientation. Accordingly, even if the crystal orientation of torsion springs parallel to the torsional axis is misaligned with the intended orientation during fabrication, the torsion spring constants of the torsion springs are substantially uniform. Thus, a variation in resonance frequency due to manufacturing error can be reduced.

The light deflector according to Example 3 torsionally oscillates about the torsional axis 308 at a frequency of f1, which serves as the reference frequency and is referred to as a primary natural oscillation mode, and at a frequency of f2, which is double the reference frequency and is referred to as a secondary natural oscillation mode. By torsionally oscillating the light deflector at the primary and secondary torsional oscillation modes simultaneously, the displacement angle of the light reflected by the reflecting surface 304 provided on the movable portion 303 during deflection and scanning is controlled by these two oscillation modes. Because the light deflector according to Example 3 has the primary torsional oscillation mode, which serves as the reference frequency, and the secondary torsional oscillation mode, which is double the reference frequency, the light deflector can be oscillated with a sawtooth waveform. This allows the light deflector to perform optical scanning with little variation in angular speed, further making the spot shape of the reflected light uniform.

Example 4

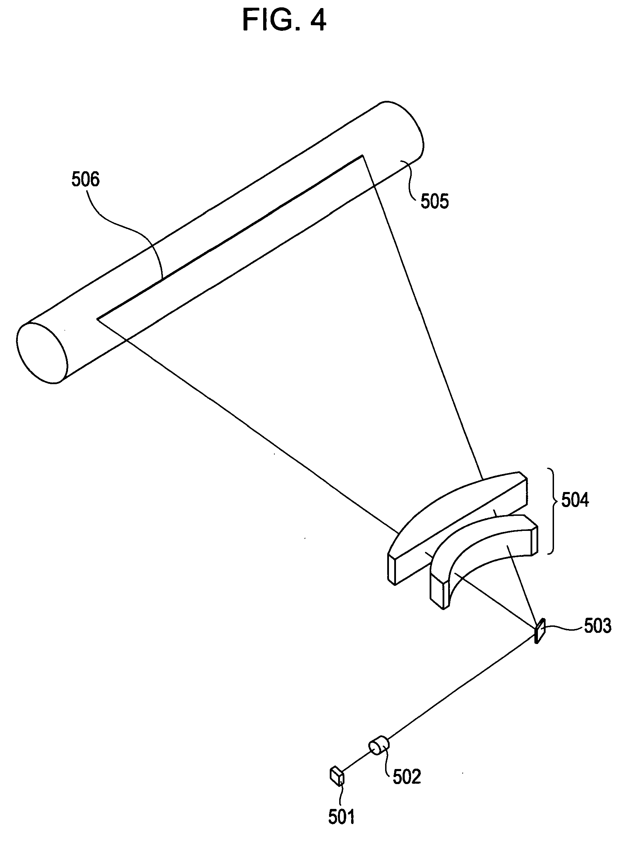

FIG. 4 is a schematic diagram of an optical apparatus according to Example 4 using the above-described light deflector. FIG. 4 is a schematic diagram of an image forming apparatus, which is an exemplary optical apparatus. FIG. 4 shows a light deflector 503 of the present invention, which deflects incident light and performs one-dimensional scanning. FIG. 4 also shows a laser source 501, a lens or a lens group 502, a writing lens or a writing lens group 504, a photosensitive body 505, and a scanning locus 506. A laser beam emitted from the laser source 501 is modulated according to the timing of deflection and scanning of light, and is caused to one-dimensionally scan the photosensitive body 505 by the light deflector 503. The scanning of the laser beam forms an image on the photosensitive body 505 through the writing lens 504. The photosensitive body 505 is uniformly charged by a charger (not shown). By scanning the photosensitive body 505 with the laser beam, an electrostatic latent image is formed thereon. A developing unit (not shown) forms a toner image on the electrostatic latent image. This toner image is transferred and fixed onto a sheet (not shown), for example, whereby an image is formed on the sheet. The use of a light deflector that maintains the flatness of the reflecting surface and has less fluctuation in frequency due to manufacturing error enables a stable image to be formed.

When a light deflector of the present invention is applied to an image display apparatus such as a projection display, the image display apparatus should be configured as follows. A light source emits a light beam modulated according to image data. The light deflector of the present invention deflects the light beam and irradiates an object with the light beam to form an image thereon. The light deflector is configured to deflect the light beam in the main and sub scanning directions of the object.

As described above, the light deflector of the present invention can be applied to the above-described optical apparatuses.

The present invention relates to oscillating devices, light deflectors, and image forming apparatuses using the light deflectors. Light deflectors are suitably used in, for example, projection displays that project images by deflecting light and performing scanning, image forming apparatuses using an electrophotography process, such as laser beam printers and digital copying machines.

While the present invention has been described with reference to exemplary embodiments, it is to be understood that the invention is not limited to the disclosed exemplary embodiments. The scope of the following claims is to be accorded the broadest interpretation.

An oscillating device is disclosed that maintains the flatness of a movable portion during driving. The oscillating device has a supporting portion (101, 201, 301), a movable portion (103, 203, 303, 305), a torsion spring (104a, 104b, 204a, 204b, 302a, 302b) connecting the movable portion to the supporting portion in a manner allowing the movable portion to torsionally oscillate about a torsional axis (108, 208, 308), and a driving unit (107, 207) configured to oscillate the movable portion. The movable portion is made of single-crystal silicon. The principal surface of the movable portion lies in the (110) crystal plane, and the crystal orientation of the movable portion parallel to the principal surface and perpendicular to the torsional axis is the [111] orientation.

**Claims**

1. An oscillating device comprising:

   a supporting portion (101, 201, 301);
   a movable portion (103, 203, 303, 305);
   a torsion spring (104a, 104b, 204a, 204b, 302a, 302b) connecting the movable portion to the supporting portion in a manner allowing the movable portion to torsionally oscillate about a torsional axis (108, 208, 308); and
   a driving unit (107, 207) configured to oscillate the movable portion,

   wherein the movable portion is made of single-crystal silicon;
   wherein a principal surface of the movable portion lies in a (110) crystal plane; and
   wherein a crystal orientation parallel to the principal surface of the movable portion and perpendicular to the torsional axis is a [111] orientation.

2. The oscillating device according to claim 1,
   wherein the torsion spring is made of single-crystal silicon, and
   wherein the crystal orientation of the torsion spring parallel to the torsional axis is the [111] orientation.

3. The oscillating device according to claim 1,
   wherein the torsion spring is made of single-crystal silicon whose principal surface lies in a (111) crystal plane.

4. The oscillating device according to claim 1,
   wherein the supporting portion, the movable portion, and the torsion spring are integrally made of single-crystal silicon.

5. A light deflector (503) comprising the oscillating device according to any one of claims 1 to 4, the oscillating device further having a reflecting surface (102, 202, 304) provided on the movable portion (103, 203, 303, 305).

6. The light deflector according to claim 5, comprising:

   a plurality of movable portions; and
   a plurality of torsion springs configured to support the plurality of movable portions in a manner allowing the movable portions to torsionally oscillate about a single torsional axis,

   wherein at least one of the plurality of movable portions has the reflecting surface, and
   wherein the plurality of movable portions oscillate about the torsional axis at a natural frequency serving as a reference frequency and at a natural frequency that is an integral multiple of the reference frequency.

7. An image forming apparatus comprising:

   a light source (501);
   the light deflector (503) according to claim 5 or 6; and
   a photosensitive body (505),

   wherein the light deflector deflects light emitted from the light source and irradiates the photosensitive body with a part of the light to form an electrostatic latent image.

**Patentansprüche**

1. Oszillierende Vorrichtung mit:

einem Trägerabschnitt (101, 201, 301);

einem beweglichen Abschnitt (103, 203, 303, 305);

einer Torsionsfeder (104a, 104b, 204a, 204b, 302a, 302b), die den beweglichen Abschnitt mit dem Trägerabschnitt in einer Art verbindet, die es dem beweglichen Abschnitt erlaubt um eine Torsionsachse (108, 208, 308) torsional zu oszillieren; und

einer Ansteuereinheit (107, 207), die dazu eingerichtet ist, den beweglichen Abschnitt zu oszillieren,

wobei der bewegliche Abschnitt aus einkristallinem Silizium hergestellt ist;

wobei eine Hauptoberfläche des beweglichen Abschnitts in einer (110)-Kristallebene liegt; und

wobei eine Kristallorientierung parallel zu der Hauptoberfläche des beweglichen Abschnitts und senkrecht zu der Torsionsachse eine [111]-Orientierung ist.

2. Oszillierende Vorrichtung nach Anspruch 1,
   wobei die Torsionsfeder aus einkristallinem Silizium hergestellt ist, und
   wobei die Kristallorientierung der Torsionsfeder parallel zur Torsionsachse die [111]-Orientierung ist.

3. Oszillierende Vorrichtung nach Anspruch 1,
   wobei die Torsionsfeder aus einkristallinem Silizium hergestellt ist, dessen Hauptoberfläche in einer (111)-Kristallebene liegt.

4. Oszillierende Vorrichtung nach Anspruch 1,
   wobei der Trägerabschnitt, der bewegliche Abschnitt und die Torsionsfeder einstückig aus einkristallinem Silizium hergestellt sind.

5. Ein Lichtablenker (503), der die oszillierende Vorrichtung nach einem der Ansprüche 1 bis 4 umfasst,
   wobei die oszillierende Vorrichtung ferner eine reflektierende Oberfläche (102, 202, 304) hat, die auf dem beweglichen Abschnitt (103, 203, 303, 305) bereitgestellt ist.

6. Lichtablenker nach Anspruch 5, mit:

   einer Vielzahl von beweglichen Abschnitten; und

   einer Vielzahl von Torsionsfedern, die dazu eingerichtet sind, die Vielzahl von beweglichen Abschnitten in einer Art zu tragen, die es den beweglichen Abschnitten erlaubt, um eine einzige Torsionsachse torsional zu oszillieren,

   wobei zumindest einer der Vielzahl von beweglichen Abschnitten die reflektierende Oberfläche aufweist, und
   wobei die Vielzahl von beweglichen Abschnitten um die Torsionsachse bei einer natürlichen Frequenz oszillieren, die als eine Referenzfrequenz dient und bei einer natürlichen Frequenz, die ein ganzzahliges Vielfaches der Referenzfrequenz ist.

7. Bilderzeugendes Gerät mit:

   einer Lichtquelle (501);

   dem Lichtablenker (503) nach Anspruch 5 oder 6; und

   einem lichtempfindlichen Körper (505),

   wobei der Lichtablenker Licht ablenkt, das von der Lichtquelle emittiert ist und den lichtempfindlichen Körper mit einem Teil des Lichts bestrahlt, um ein elektrostatisches latentes Bild zu bilden.

**Revendications**

1. Dispositif oscillant comprenant :

   une partie (101, 201, 301) formant support ;

   une partie mobile (103, 203, 303, 305) ;

   un ressort de torsion (104a, 104b, 204a, 204b, 302a, 302b) reliant la partie mobile à la partie formant support de manière à permettre à la partie mobile d'osciller en torsion autour d'un axe (108, 208, 308) de torsion ; et

   une unité (107, 207) d'entraînement constituée pour faire osciller la partie mobile,

dans lequel la partie mobile est faite de silicium monocristallin ;

dans lequel une surface principale de la partie mobile se trouve dans un plan (110) de cristal ; et

dans lequel une orientation de cristal parallèle à la surface principale de la partie mobile et perpendiculaire à l'axe de torsion est une orientation [111].

2.  Dispositif oscillant selon la revendication 1,

dans lequel le ressort de torsion est fait de silicium monocristallin, et

dans lequel l'orientation de cristal du ressort de torsion parallèle à l'axe de torsion est l'orientation [111].

3.  Dispositif oscillant selon la revendication 1, dans lequel le ressort de torsion est fait de silicium monocristallin dont la surface principale se trouve dans un plan (111) de cristal.

4.  Dispositif oscillant selon la revendication 1, dans lequel la partie formant support, la partie mobile, et le ressort de torsion sont faits d'un seul tenant de silicium monocristallin.

5.  Déflecteur (503) de lumière comprenant le dispositif oscillant selon l'une quelconque des revendications 1 à 4, le dispositif oscillant comportant en outre une surface réfléchissante (102, 202, 304) disposée sur la partie mobile (103, 203, 303, 305).

6.  Déflecteur de lumière selon la revendication 5, comprenant :

une pluralité de parties mobiles ; et

une pluralité de ressorts de torsion constituée pour supporter la pluralité de parties mobiles d'une manière permettant aux parties mobiles d'osciller en torsion autour d'un même axe de torsion,

dans lequel au moins l'une de la pluralité de parties mobiles comporte une surface réfléchissante, et

dans lequel la pluralité de parties mobiles oscille autour de l'axe de torsion à une fréquence propre servant de fréquence de référence et à une fréquence propre qui est un multiple entier de la fréquence de référence.

7.  Appareil de formation d'image comprenant :

une source (501) de lumière ;

un déflecteur (503) de lumière selon la revendication 5 ou 6 ; et

un corps photosensible (505),

dans lequel le déflecteur de lumière dévie la lumière émise par la source de lumière et éclaire le corps photosensible avec une partie de la lumière pour former une image latente électrostatique.

## FIG. 1A

101

108

104a

102

IB        IB

103

104b

1000 { (110)    [100]

[111]

[110]

## FIG. 1B

[110]

[111]    } 1001

103 102        104

106

107

FIG. 2A

FIG. 2B

# FIG. 3

# FIG. 4

# FIG. 5A

401             402

403

# FIG. 5B

402

401

$\delta$

Q

403

# FIG. 5C

Wh

X      $\sigma$

t

403      401

Y

## FIG. 6

## FIG. 7

FIG. 8
PRIOR ART

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4317611 A